# EUROPEAN PATENT SPECIFICATION

(11) **EP 4 571 455 B1**
(45) Date of publication and mention of the grant of the patent: **27.05.2026**
(21) Application number: 24211749.7
(22) Date of filing: 08.11.2024
(51) Int. Cl.: G06F 1/16, B65D 43/02, H04M 1/02, H05K 5/03

(54) **COVER HOLDING STRUCTURE FOR AN ELECTRONIC DEVICE**
ABDECKUNGSHALTESTRUKTUR FÜR EIN ELEKTRONISCHES GERÄT
STRUCTURE DE MAINTIEN DE COUVERCLE POUR UN DISPOSITIF ÉLECTRONIQUE

(30) Priority: 30.11.2023 JP 2023202713
(43) Date of publication of application: 18.06.2025
(73) Proprietor: CASIO COMPUTER CO., LTD., Tokyo 151-8543 (JP)
(72) Inventor: Eguchi, Hiroki, Hamura-shi, Tokyo, 205-8555 (JP); Tozuka, Takumi, Hamura-shi, Tokyo, 205-8555 (JP)
(74) Representative: Grünecker Patent- und Rechtsanwälte PartG mbB

(56) References cited:
- WO-A1-2015/013933
- JP-A- H08 255 604
- JP-U- S5 234 041
- JP-U- S54 172 606
- JP-Y2- H0 238 370
- US-B2- 8 212 708

## Description

### TECHNICAL FIELD

The present disclosure relates to a cover holding structure and a device.

### DESCRIPTION OF RELATED ART

There is known a lock structure configured to lock a cover to a case by a hook structure (for example, see JP H8-255604A).

The lock structure disclosed in JP H8-255604A securely maintains the locked state of the cover even if the case receives an impact by being dropped, for example. To unlock the cover, a manipulation part of the cover needs to be forcefully pulled up, as described in [0013] of the description of JP H8-255604A. Therefore, the lock structure is not easy to manipulate.

The present disclosure has been conceived in view of the above and is aimed to make it easier to unlock the engagement between a casing and a cover.

### SUMMARY OF THE INVENTION

To solve the above problem, according to the present disclosure, there is provided a cover holding structure for a cover configured to cover an opening of a casing, the cover holding structure including: an engaging target part formed on the casing; and an engaging part formed on the cover, wherein in a state where the opening of the casing is covered by the cover, the engaging part is biased toward the engaging target part; the engaging part includes an engaging surface and a second surface, and, in the state where the opening of the casing is covered by the cover, the engaging surface is engaged with an engaging target surface of the engaging target part, and the second surface faces a first surface of the engaging target part with a predetermined distance from the first surface; and the predetermined distance is determined so as to prevent interference between the first surface of the engaging target part and the second surface of the engaging part when the opening of the casing is uncovered by the cover by moving the engaging part in a direction of separating from the engaging target part.

### Advantageous Effects of Invention

According to the present disclosure, the engagement between a case and a cover can be easily released.

### BRIEF DESCRIPTION OF DRAWINGS

The accompanying drawings are not intended as a definition of the limits of the invention but illustrate embodiments of the invention, and together with the general description given above and the detailed description of the embodiments given below, serve to explain the principles of the invention, wherein:
FIG.1 is a plan view of the back surface of a scientific calculator as an embodiment of a device to which the present disclosure is applied;
FIG.2 is a perspective view of the lower part of the back surface of the scientific calculator;
FIG.3 is a plan view of the cover viewed from the front;
FIG.4 is an enlarged lateral view of a part of the cover including a hook;
FIG.5 is a cross-sectional view along the A-A line in FIG.1;
FIG.6A is an enlarged view of the area enclosed by the single-dotted line in FIG.5;
FIG.6B shows a state where a finger-putting part is moved in a direction of bringing a manipulation part closer to a base part from the state shown in FIG.6A;
FIG.7 shows a state where an engaging part is engaged with an engaging target part; and
FIG.8 is a cross-sectional view along the A-A line in FIG.1 in a state the opening is uncovered.

### DETAILED DESCRIPTION

Hereinafter, an embodiment of a device and a cover holding structure of the present disclosure is described with reference to the figures. In the following embodiment, a scientific calculator is used as an example of a device to which the present disclosure is applied. However, the device is not limited to a scientific calculator. The present disclosure is applicable to any device (e.g., an electronic dictionary or a tablet terminal) that is provided with a cover 20 configured to cover an opening 11 of a casing 10, which are described later.

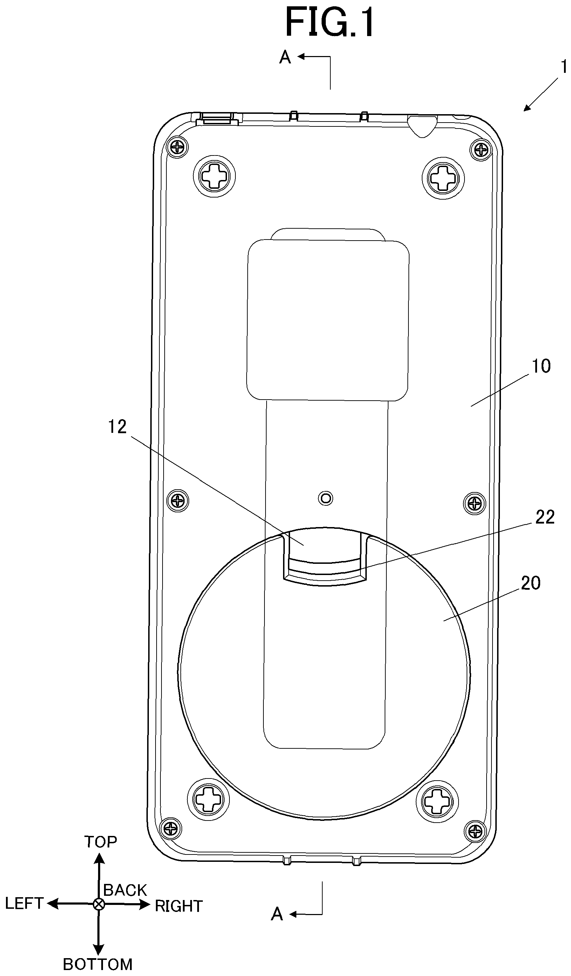

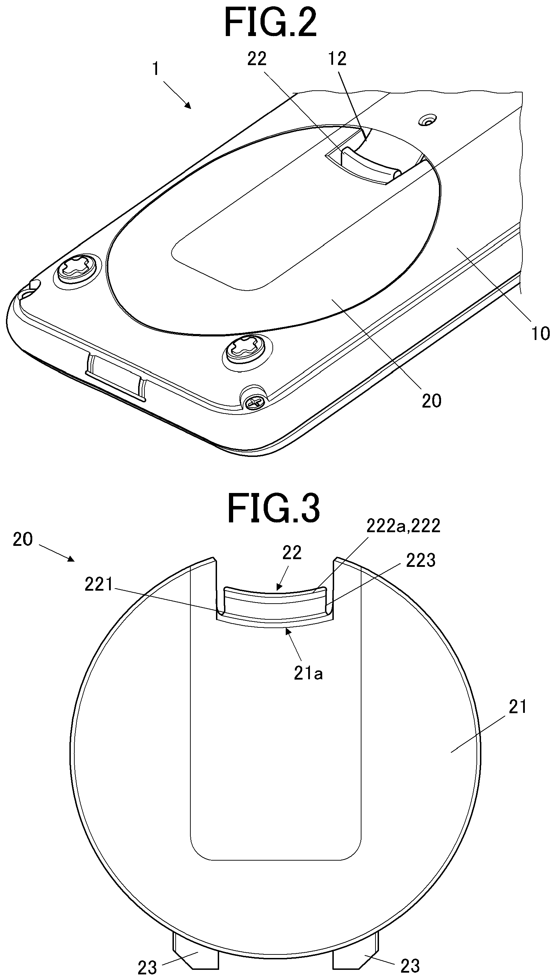

As shown in FIG.1 and FIG.2, the scientific calculator 1 includes a casing 10 and a cover (cover body) 20. FIG. 1 shows the top-bottom direction, the left-right direction, and the front-back direction that are perpendicular to each other. The front-back direction corresponds to the thickness direction of the casing 10.

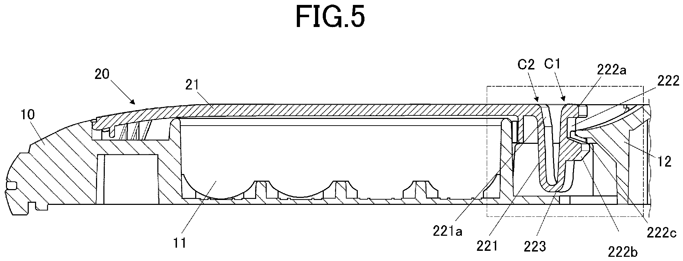

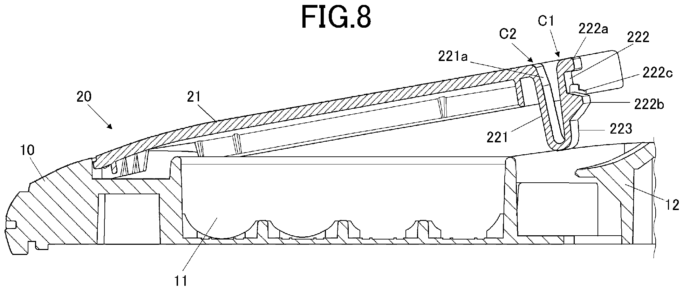

On the back of the casing 10, an opening 11 is formed to house (load) not-illustrated four dry cell batteries or not-illustrated dry-cell-type secondary batteries (see FIG.5 and FIG.8).

The opening 11 has a round shape corresponding to the external round shape of the cover 20 (see FIG.3). By attaching the cover 20, the opening 11 is covered.

As shown in FIG.1 and FIG.5, an engaging target part (engaging target region) 12 is provided at a specific position of the opening 11 corresponding to a hook 22 (described later) of the cover 20. The engaging target part 12 is engaged with the hook 22 when the cover 20 is attached.

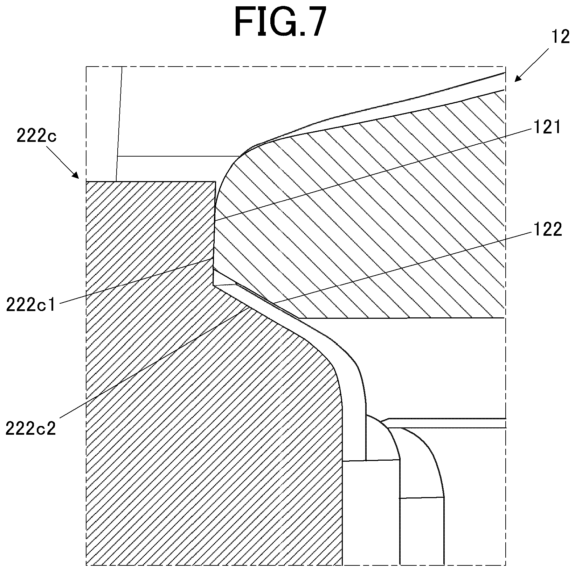

The engaging target part 12 is formed like an eave that projects from the edge of the opening 11 toward the center of the opening 11 while sloping downward. As shown in FIG.7, the engaging target part 12 includes an engaging target surface 121. The engaging target surface 121 is formed to be engaged with an engaging surface 222c1 of each rib 222c formed on the hook 22. The ribs 222c are described later. The engaging target part 12 has a sloping surface 122 (first surface) adjacent to the engaging target surface 121. When the engaging target surface 121 is engaged with the engaging surface 222c1 of each rib 222c (described later), namely when the cover 20 is attached to the casing 10, the sloping surface 122 faces the sloping surfaces 222c2 (second surface) of the ribs 222c with a predetermined distance from the sloping surfaces 222c2. The predetermined distance is determined so as to prevent rattling, which is caused by an impact on the cover 20 or the casing 10. Thus, rattling caused by an impact on the cover 20 or the casing 10 can be appropriately prevented.

At predetermined positions of the opening 11 (the positions corresponding to locking parts 23 of the cover 20, which are described later), locking holes are formed although not illustrated. The locking parts 23 are locked (inserted) to the locking holes when the cover 20 is attached.

As shown in FIG.3, the cover 20 includes a cover body 21, the hook 22 (elastic member), and the locking parts 23.

The cover body 21 is for covering the opening 11 of the casing 10. The cover body 21 has a round shape (disk shape) corresponding to the round-shaped opening 11. Part of the cover body 21 corresponding to the engaging target part 12 of the casing 10 is notched. The hook 22 is formed at the inner end 21a of the notch.

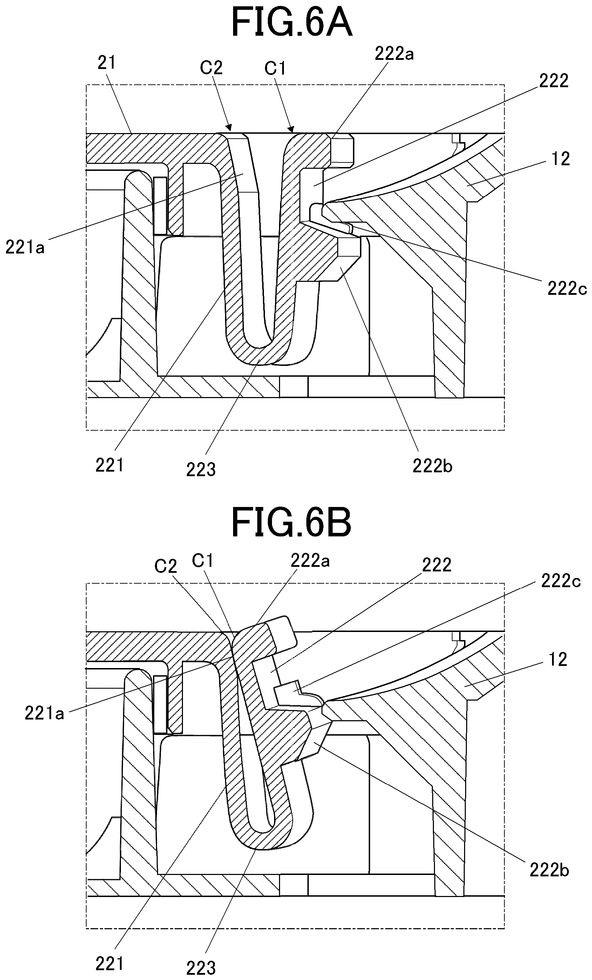

The hook 22 is formed to engage the cover 20 with the casing 10. Specifically, as shown in FIG.3 and FIG.6A, the hook 22 is a plate spring hook and includes a base part (second region) 221, a manipulation part (first region) 222, and a connecting part 223. The base part 221 protrudes substantially in the thickness direction of the casing 10 from the back surface side of the end 21a of the cover body 21. The direction in which the base part 221 protrudes may not be identical to the thickness direction. The back surface side of the cover 20 is the side that faces the casing 10 when the cover 20 is attached to the casing 10. The manipulation part 222 is formed to face the base part 221. The connecting part 223 connects the base part 221 and the manipulation part 222. When the cover 20 is attached to the casing 10, the hook 22 is biased toward the engaging target part 12. The hook 22 is not limited to a plate spring hook as long as the hook 22 is biased toward the engaging target part 12 when the cover 20 is attached to the casing 10. The hook 22 may be a hook using other biasing means, such as a coil spring or a rubber.

The manipulation part 222 includes a finger-putting part (finger-putting region) 222a. In removing the cover 20 from the casing 10, the finger-putting part 222a is moved in the direction of loosening the engagement between the casing 10 and the cover 20 (in the direction from top to bottom in FIG.1).

The finger-putting part 222a has a hook shape and is formed at the free end of the manipulation part 222 opposite the end connected to the connecting part 223. As shown in FIG.3, the finger-putting part 222a has a curved shape that is depressed in the direction of loosening the engagement between the casing 10 and the cover 20 (in the direction from top to bottom in FIG.1). That is, the finger-putting part 222a is depressed in the direction opposite the arc-shaped depression of the part of the opening 11 corresponding to the finger-putting part 222a, the part of the opening 11 being provided with the engaging target part 12. The finger-putting part 222a is formed not to protrude from the outer surface of the casing 10 when the cover 20 covers the casing 10. As shown in FIG.6A, the finger-putting part 222a has a crook-shaped corner C1. The corner C1 is rounded (the sharp edge of the corner C1 is removed).

The manipulation part 222 has an engaging part (engaging region) 222b between one end connected to the connecting part 223 and the other end having the finger-putting part 222a. The engaging part 222b is formed to be engaged with the engaging target part 12 formed on the casing 10. As shown in FIG.5 and FIG.6A, the upper surface of the engaging part 222b slopes downward toward the engaging target part 12. On the upper surface of the engaging part 222b, ribs 222c are formed.

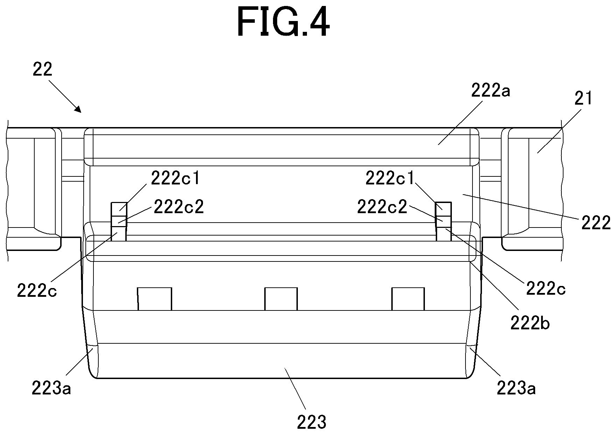

As shown in FIG.4, two ribs 222c are provided at a predetermined distance from each other in the width direction of the engaging part 222b. As shown in FIG.4 and FIG.7, each rib 222c has an engaging surface 222c1 and a sloping surface 222c2 adjacent to the lower end of the engaging surface 222c1.

As shown in FIG.7, the engaging surface 222c1 is formed to be engaged with the engaging target surface 121 of the engaging target part 12 of the casing 10. When the engaging surface 222c1 is engaged with the engaging target surface 121, namely when the cover 20 is attached to the casing 10, the manipulation part 222 is pushed toward the base part 221 by the engaging target part 12. That is, when the cover 20 is attached to the casing 10, the manipulation part 222 (hook 22) is biased toward the engaging target part 12. In the state where the engaging surfaces 222c1 of the ribs 222c are engaged with the engaging target surface 121 of the engaging target part 12, the ribs 222c prevent rattling and serve to determine the position of the cover 20 in the height direction (the thickness direction of the casing 10).

The sloping surface 222c2 slopes downward toward the engaging target part 12, as shown in FIG.7. When the engaging surfaces 222c1 are engaged with the engaging target surface 121, namely when the cover 20 is attached to the casing 10, the sloping surfaces 222c2 face the sloping surface 122 of the engaging target part 12 with a predetermined distance from the sloping surface 122.

The connecting part 223 connects the base part 221 and the manipulation part 222, as described above. As shown in FIG.6A, the connecting part 223 is U-shaped when viewed from the lateral side. The manipulation part 222, which includes the engaging part 222b, is swingable in the direction of separating from the engaging target part 12 (toward the base part 221) or in the direction toward the engaging target part 12 (separating from the base part 221) on the lowest end of the connecting part 223 as the center. The axis is the center of the connecting part 223 in the width direction of the connecting part 223. In this embodiment, the base part 221, the manipulation part 222, the engaging part 222b, and the connecting part 223 of the hook 22 have the curved shape depressed in the direction of loosening the engagement between the casing 10 and the cover 20 so as to correspond to the curved shape of the finger-putting part 222a (see FIG.3). When the finger-putting part 222a is moved in the direction of loosening the engagement between the casing 10 and the cover 20 to detach the cover 20 from the casing 10, stress tends to concentrate on both ends of the connecting part 223 in the width direction. To deal with the stress, as shown in FIG.4, chamfered parts 223a are formed on both ends of the connecting part 223 in the width direction. That is, both ends of the connecting part 223 in the width direction (in the left-right direction in FIG.1) are cut off. This reduces the concentration of stress on both ends of the connecting part 223 in the width direction.

The base part 221 protrudes from the back surface side of the inner end 21a of the cover body 21, as described above. As shown in FIG.5 and FIG.6A, the base part 221 has a chamfered part 221a at an L-shaped corner C2, which is formed by the base part 221 and the cover body 21. The chamfered part 221a is formed at a part of the base part 221 that abuts the corner C1 of the finger-putting part 222a when the finger-putting part 222a is moved in the direction of loosening the engagement between the casing 10 and the cover 20. The chamfered part 221a is formed at an angle (relief angle) corresponding to the leaning angle of the manipulation part 222 when the finger-putting part 222a abuts the base part 221. In other words, in the region (corner C2) of the base part 221 opposite the corner C1 of the finger-putting part 222a of the manipulation part 222, the chamfered part 221a is formed with a relief shape at a relief angle. The relief angle corresponds to the angle of the manipulation part 222 in contact with (abutting) the base part 221 when the finger-putting part 222a is moved in the direction of bringing the manipulation part 222 toward the base part 221. FIG.6B shows the state where the finger-putting part 222a is moved from the state of FIG.6A in the direction of bringing the manipulation part 222 toward the base part 221. The chamfered part 221a is at a position where the manipulation part 222 abuts the base part 221, and the chamfered part 221a is at an angle corresponding to the leaning angle of the manipulation part 222 abutting the base part 221. In this embodiment, the corner C1 of the finger-putting part 222a is rounded, and the chamfered part 221a is formed on the base part 221. Such a structure increases the stroke amount (moving amount) of the finger-putting part 222a even if there is not enough moving distance. Thus, the engagement between the casing 10 and the cover 20 is certainly released when the finger-putting part 222a is moved in the direction of loosening the engagement between the casing 10 and the cover 20. Herein, the rounded corner may be formed on the corner C2, and the chamfered part 221a may be formed on the manipulation part 222.

The locking parts 23 are inserted into the not-illustrated locking holes formed in the opening 11, thereby being engaged with the locking holes. Two locking parts 23 are formed on the edge of the cover body 21. Specifically, the locking parts 23 are formed on the edge of the cover body 21 such that the locking parts 23 and the hook 22 form an isosceles triangle.

The cover 20 is supported by the hook 22 and the two locking parts 23. The cover body 21, the hook 22, and the locking parts 23 are formed as one body.

In the structure described above, dry cell batteries or dry-cell-type secondary batteries are housed in a predetermined position in the opening 11, and the locking parts 23 of the cover 20 are inserted into the not-illustrated locking holes of the opening 11. In the state shown in FIG.8, by pressing the cover 20 from above, the cover body 21 of the cover 20 is fitted into the opening 11; and the hook 22 of the cover 20 bends inward to engage with the engaging target part 12. Thus, the cover 20 is fixed to the casing 10, as shown in FIG.5. In the state the cover 20 is fixed, by moving the finger-putting part 222a of the hook 22 in the direction of loosening the engagement between the casing 10 and the cover 20 (in the direction toward the base part 221), the engagement between the hook 22 and the engaging target part 12 is released, and the opening 11 is uncovered, as shown in FIG.8. Herein, since the ribs 222c each have the sloping surface 222c2 (see FIG.7), the corner of the engaging target part 12 formed by the engaging target surface 121 and the sloping surface 122 does not interfere with (does not contact) the engaging part 222b of the hook 22. Thus, the engagement between the casing 10 and cover 20 can be smoothly released.

As described above, the scientific calculator 1 in the embodiment includes: the casing 10 that includes the engaging target part 12; and the cover 20 that is configured to cover the casing 10 and that includes the engaging part 222b (ribs 222c). In a state where the opening 11 of the casing 10 is covered by the cover 20, the engaging part 222b is biased toward the engaging target part 12. The engaging part 222b includes the engaging surfaces 222c1 and the sloping surfaces 222c2 (second surface). In a state where the opening 11 of the casing 10 is covered by the cover 20, the engaging surfaces 222c1 are engaged with the engaging target surface 121 of the engaging target part 12, and the sloping surfaces 222c2 (second surface) face the sloping surface 122 (first surface) of the engaging target part 12 with a predetermined distance from the sloping surface 122. The predetermined distance is determined so as to prevent interference between the sloping surface 122 of the engaging target part 12 and the sloping surfaces 222c2 of the engaging part 222b when the opening 11 of the casing 10 is uncovered by the cover 20 by moving the engaging part 222b in a direction of separating from the engaging target part 12.

Thus, according to the scientific calculator 1, the predetermined distance is determined so as to prevent interference between the sloping surface 122 of the engaging target part 12 and the sloping surfaces 222c2 of the engaging part 222b when the cover 20 is detached from the casing 10. Such a structure allows smooth disengagement between the casing 10 and the cover 20. Thus, the engagement between the casing 10 and the cover 20 can be easily released.

Further, the engaging part 222b of the cover 20 is swingable on a predetermined axis; and the predetermined distance is determined so as to prevent interference between the sloping surface 122 (first surface) of the engaging target part 12 and the sloping surfaces 222c2 (second surface) of the engaging part 222b when the opening 11 of the casing 10 is uncovered by the cover 20 by swinging, on the predetermined axis, the engaging part 222b of the cover 20 attached to the casing 10 in a direction of separating from the engaging target part 12.

Thus, according to the scientific calculator 1, the predetermined distance is determined so as to prevent interference between the sloping surface 122 of the engaging target part 12 and the sloping surfaces 222c2 of the engaging part 222b when the cover 20 is detached from the casing 10. Such a structure allows smooth disengagement between the casing 10 and the cover 20. Thus, the engagement between the casing 10 and the cover 20 can be easily released.

Further, in a state where the opening 11 of the casing 10 is covered by the cover 20, the sloping surface 122 (first surface) of the engaging target part 12 of the casing 10 slopes downward from the engaging surfaces 222c1 of the cover 20 toward the engaging target part 12 of the casing 10. Further, in a state where the opening 11 of the casing 10 is covered by the cover 20, the sloping surfaces 222c2 (second surface) of the engaging part 222b of the cover 20 slope downward from the engaging surfaces 222c1 of the cover 20 toward the engaging target part 12 of the casing 10. That is, the sloping surface 122 (first surface) of the engaging target part 12 and the sloping surfaces 222c2 (second surface) of the engaging part 222b are at a predetermined angle to a thickness direction of the casing 10.

Thus, according to the scientific calculator 1, when the cover 20 is detached from the casing 10, the interference between the sloping surface 122 of the engaging target part 12 and the sloping surfaces 222c2 of the engaging part 222b can be appropriately prevented.

Further, the sloping surfaces 222c2 of the engaging part 222b are positioned at the predetermined distance from the sloping surface 122 (first surface) of the engaging target part 12 in the state where the opening 11 of the casing 10 is covered by the cover 20. The predetermined distance is determined so as to prevent rattling that is caused by an impact on the cover 20 or the casing 10.

Thus, according to the scientific calculator 1, rattling can be appropriately prevented, which is caused by an impact on the cover 20 or the casing 10.

Further, the engaging part 222b of the cover 20 has a curved shape depressed in a direction of loosening the engagement between the cover 20 and the casing 10; and the engaging target part 12 of the casing 10 has a curved shape protruding toward the engaging part 222b so as to correspond to the curved shape of the engaging part 222b. Thus, the engagement between the cover 20 and the casing 10 can be appropriately retained.

Although the embodiment of the present disclosure has been described in detail, the above embodiment does not limit the present disclosure and can be modified without departing from the scope of the present disclosure.

For example, although the opening 11 of the casing 10 has a round shape in the above embodiment, the opening 11 is not limited to a round shape. The opening 11 may have a rectangular or oval shape, for example. If the opening 11 is rectangular, the cover body 21 has a shape corresponding to the rectangular opening 11.

In the above embodiment, the corner C1 of the finger-putting part 222a is rounded, and the chamfered part 221a is formed on the base part 221. However, as long as the corner C1 of the finger-putting part 222a is rounded, the base part 221 may not have the chamfered part 221a, for example. For another example, as long as the base part 221 has the chamfered part 221a, the corner C1 of the finger-putting part 222a may not be rounded.

In the above embodiment, the locking parts 23 of the cover 20 are fitted into not-illustrated locking holes formed at predetermined positions of the opening 11. However, the cover 20 may be coupled to the casing 10 by a hinge that allows opening and closing of the opening 11, for example. In this case, the cover 20 is not completely detached from the casing 10.

In the above embodiment, the shape of the curved surface of the sloping surface 222c2 may be matched to the shape of the movement locus of the sloping surface 222c2 when the engaging part 222b of the lid member 10 is swung. Such a structure prevents the cover 20 from moving upward by the impact on the cover 20 or the casing 10, thereby preventing the detachment of the cover 20 from the casing 10. Such a structure also allows proper disengagement of the cover 20 from the casing 10.

It is of course possible to change the detailed configuration of the components of the scientific calculator 1 in the above embodiment without departing from the scope of the present disclosure.

## Claims

1. A cover holding structure for a cover (20) configured to cover an opening (11) of a casing (10), the cover holding structure comprising:
an engaging target part (12) formed on the casing; and
an engaging part (222b) formed on the cover, wherein
in a state where the opening of the casing is covered by the cover, the engaging part is biased toward the engaging target part;
the engaging part includes an engaging surface (222c1) and a second surface (222c2), and, in the state where the opening of the casing is covered by the cover, the engaging surface is engaged with an engaging target surface (121) of the engaging target part,
**characterized in that** the second surface faces a first surface (122) of the engaging target part with a predetermined distance from the first surface; and
the predetermined distance is determined so as to prevent interference between the first surface of the engaging target part and the second surface of the engaging part when the opening of the casing is uncovered by the cover by moving the engaging part in a direction of separating from the engaging target part.

2. The cover holding structure according to claim 1, wherein
the engaging part is swingable on a predetermined axis; and
the predetermined distance is determined so as to prevent interference between the first surface of the engaging target part and the second surface of the engaging part when the opening of the casing is uncovered by the cover by swinging, on the predetermined axis, the engaging part of the cover attached to the casing in the direction of separating from the engaging target part.

3. The cover holding structure according to claim 1 or claim 2, wherein
in the state where the opening of the casing is covered by the cover, the first surface of the engaging target part slopes downward from the engaging surface of the cover toward the engaging target part of the casing.

4. The cover holding structure according to any one of claims 1 to 3, wherein
in the state where the opening of the casing is covered by the cover, the second surface of the engaging part slopes downward from the engaging surface of the cover toward the engaging target part of the casing.

5. The cover holding structure according to any one of claims 1 to 4, wherein the first surface of the engaging target part and the second surface of the engaging part are at a predetermined angle to a thickness direction of the casing.

6. The cover holding structure according to any one of claims 1 to 5, wherein the predetermined distance is determined so as to prevent rattling that is caused by an impact on the cover or the casing.

7. The cover holding structure according to any one of claims 1 to 6, wherein
the engaging part has a curved shape depressed in a direction of loosening an engagement between the cover and the casing; and
the engaging target part has a curved shape protruding toward the engaging part so as to correspond to the curved shape of the engaging part.

8. A device (1) comprising:
the casing (10);
the cover (20); and
the cover holding structure according to any one of claims 1 to 7.

## Patentansprüche

1. Abdeckungs-Haltestruktur für eine Abdeckung (20), die zum Abdecken einer Öffnung (11) eines Gehäuses (10) ausgeführt ist, wobei die Abdeckungs-Haltestruktur umfasst:
einen Eingriffsziel-Teil (12), der an dem Gehäuse ausgebildet ist; sowie
einen eingreifenden Teil (222b), der an der Abdeckung ausgebildet ist, wobei
in einem Zustand, in dem die Öffnung des Gehäuses durch die Abdeckung abgedeckt wird, der eingreifende Teil in Richtung des Eingriffsziel-Teils zu gespannt wird;
der eingreifende Teil eine eingreifende Fläche (222c1) sowie eine zweite Fläche (222c2) aufweist und in dem Zustand, in dem die Öffnung des Gehäuses durch die Abdeckung abgedeckt wird, die eingreifende Fläche in Eingriff mit einer Eingriffsziel-Fläche (121) des Eingriffsziel-Teils ist,
**dadurch gekennzeichnet, dass**
die zweite Fläche einer ersten Fläche (122) des Eingriffsziel-Teils mit einem vorgegebenen Abstand zu der ersten Fläche zugewandt ist; und
der vorgegebene Abstand so bestimmt wird, dass gegenseitige Behinderung der ersten Fläche des Eingriffsziel-Teils und der zweiten Fläche des eingreifenden Teils verhindert wird, wenn die Öffnung des Gehäuses durch die Abdeckung freigelegt wird, indem der eingreifende Teil in einer Richtung zum Trennen von dem Eingriffsziel-Teil bewegt wird.

2. Abdeckungs-Haltestruktur nach Anspruch 1, wobei
der eingreifende Teil auf einer vorgegebenen Achse geschwenkt werden kann;
und
der vorgegebene Abstand so bestimmt wird, dass gegenseitige Behinderung der ersten Fläche des Eingriffsziel-Teils und der zweiten Fläche des eingreifenden Teils verhindert wird, wenn die Öffnung des Gehäuses durch die Abdeckung freigelegt wird, indem der eingreifende Teil der an dem Gehäuse angebrachten Abdeckung in der Richtung zum Trennen von dem Eingriffsziel-Teil auf der vorgegebenen Achse geschwenkt wird.

3. Abdeckungs-Haltestruktur nach Anspruch 1 oder Anspruch 2, wobei
in dem Zustand, in dem die Öffnung des Gehäuses durch die Abdeckung abgedeckt wird, die erste Fläche des Eingriffsziel-Teils von der eingreifenden Fläche der Abdeckung aus in Richtung des Eingriffsziel-Teils des Gehäuses nach unten abgeschrägt ist.

4. Abdeckungs-Haltestruktur nach einem der Ansprüche 1 bis 3, wobei
in dem Zustand, in dem die Öffnung des Gehäuses durch die Abdeckung abgedeckt wird, die zweite Fläche des eingreifenden Teils von der eingreifenden Fläche der Abdeckung aus in Richtung des Eingriffsziel-Teils des Gehäuses nach unten abgeschrägt ist.

5. Abdeckungs-Haltestruktur nach einem der Ansprüche 1 bis 4, wobei die erste Fläche des Eingriffs-Zielteils und die zweite Fläche des eingreifenden Teils in einem vorgegebenen Winkel zu einer Dickenrichtung des Gehäuses liegen.

6. Abdeckungs-Haltestruktur nach einem der Ansprüche 1 bis 5, wobei der vorgegebene Abstand so bestimmt wird, dass Klappern vermieden wird, das durch einen Aufschlag an der Abdeckung oder dem Gehäuse verursacht wird.

7. Abdeckungs-Haltestruktur nach einem der Ansprüche 1 bis 6, wobei
der eingreifende Teil eine gekrümmte Form hat, die in einer Richtung zum Lösen eines Eingriffs zwischen der Abdeckung und dem Gehäuse vertieft ist; und
der Eingriffsziel-Teil eine gekrümmte Form hat, die in Richtung des eingreifenden Teils so vorsteht, dass sie der gekrümmten Form des eingreifenden Teils entspricht.

8. Vorrichtung (1), die umfasst:
das Gehäuse (10);
die Abdeckung (20); sowie
die Abdeckungs-Haltestruktur nach einem der Ansprüche 1 bis 7.

## Revendications

1. Structure de maintien de couvercle destinée à un couvercle (20) conçu pour recouvrir une ouverture (11) d'un boîtier (10), la structure de maintien de couvercle comprenant :
une pièce cible de mise en prise (12) formée sur le boîtier ; et
une pièce de mise en prise (222b) formée sur le couvercle, dans laquelle
dans un état dans lequel l'ouverture du boîtier est recouverte par le couvercle, la pièce de mise en prise est sollicitée en direction de la pièce cible de mise en prise ;
la pièce de mise en prise comporte une surface de mise en prise (222c1) et une seconde surface (222c2), et, dans l'état dans lequel l'ouverture du boîtier est recouverte par le couvercle, la surface de mise en prise est en prise avec une surface cible de mise en prise (121) de la pièce cible de mise en prise,
**caractérisée en ce que** la seconde surface fait face à une première surface (122) de la pièce cible de mise en prise suivant une distance prédéfinie de la première surface ; et
la distance prédéfinie est définie de façon à empêcher une interférence entre la première surface de la pièce cible de mise en prise et la seconde surface de la pièce de mise en prise lorsque l'ouverture du boîtier est découverte par le couvercle par déplacement de la pièce de mise en prise dans une direction de séparation de la pièce cible de mise en prise.

2. Structure de maintien de couvercle selon la revendication 1, dans laquelle
la pièce de mise en prise peut basculer suivant un axe prédéfini ; et
la distance prédéfinie est définie de façon à empêcher une interférence entre la première surface de la pièce cible de mise en prise et la seconde surface de la pièce de mise en prise lorsque l'ouverture du boîtier est découverte par le couvercle par basculement, suivant l'axe prédéfini, de la pièce de mise en prise du couvercle fixé au boîtier dans la direction de séparation de la pièce cible de mise en prise.

3. Structure de maintien de couvercle selon la revendication 1 ou la revendication 2, dans laquelle
dans l'état dans lequel l'ouverture du boîtier est recouverte par le couvercle, la première surface de la pièce cible de mise en prise est inclinée vers le bas depuis la surface de mise en prise du couvercle en direction de la pièce cible de mise en prise du boîtier.

4. Structure de maintien de couvercle selon l'une quelconque des revendications 1 à 3, dans laquelle
dans l'état dans lequel l'ouverture du boîtier est recouverte par le couvercle, la seconde surface de la pièce de mise en prise est inclinée vers le bas depuis la surface de mise en prise du couvercle en direction de la pièce cible de mise en prise du boîtier.

5. Structure de maintien de couvercle selon l'une quelconque des revendications 1 à 4, dans laquelle la première surface de la pièce cible de mise en prise et la seconde surface de la pièce de mise en prise se trouvent à un angle prédéfini dans une direction d'épaisseur du boîtier.

6. Structure de maintien de couvercle selon l'une quelconque des revendications 1 à 5, dans laquelle la distance prédéfinie est définie de façon à empêcher le cliquetis causé par un choc sur le couvercle ou le boîtier.

7. Structure de maintien de couvercle selon l'une quelconque des revendications 1 à 6, dans laquelle
la pièce de mise en prise présente une forme incurvée enfoncée dans une direction de relâchement d'une prise entre le couvercle et le boîtier ; et
la pièce cible de mise en prise présente une forme incurvée saillante en direction de la pièce de mise en prise de façon à correspondre à la forme incurvée de la pièce de mise en prise.

8. Dispositif (1) comprenant :
le boîtier (10) ;
le couvercle (20) ; et
la structure de maintien de couvercle selon l'une quelconque des revendications 1 à 7.
